# EUROPÄISCHE PATENTSCHRIFT

(11) **EP 1 272 864 B1**
(45) Veröffentlichungstag und Bekanntmachung des Hinweises auf die Patenterteilung: **19.01.2005**
(21) Anmeldenummer: 01927849.8
(22) Anmeldetag: 02.04.2001
(51) Int. Cl.: G01R 33/30

(54) **VORRICHTUNG UND VERFAHREN ZUR DURCHFÜHRUNG VON PRÄPARATION UND NMR-MESSUNG VON PROBEN**
DEVICE AND METHOD FOR PREPARING AND CARRYING OUT NMR MEASUREMENTS OF SAMPLES
DISPOSITIF ET PROCEDE SERVANT A PREPARER ET A EFFECTUER DES MESURES RMN SUR DES ECHANTILLONS

(30) Priorität: 03.04.2000 DE 10016568
(43) Veröffentlichungstag der Anmeldung: 08.01.2003
(73) Patentinhaber: BASF AKTIENGESELLSCHAFT, 67056 Ludwigshafen (DE)
(72) Erfinder: MAIER, Walter, 68161 Mannheim (DE); ZERWECK, Johannes, 14193 Berlin (DE); GRÜLL, Michael, 67435 Neustadt (DE); RICHERT, Joachim, 67127 Rödersheim-Gronau (DE)
(74) Vertreter: Isenbruck, Günter, Dr.
(86) Internationale Anmeldenummer: PCT/EP2001/003730
(87) Internationale Veröffentlichungsnummer: WO 2001/075467

(56) Entgegenhaltungen:
- DE-C- 4 104 075
- US-A- 5 397 989
- PATENT ABSTRACTS OF JAPAN vol. 017, no. 369 (P-1572), 12. Juli 1993 (1993-07-12) & JP 05 060736 A (JASCO CORP), 12. März 1993 (1993-03-12)

## Beschreibung

Die Erfindung bezieht sich auf eine Vorrichtung und Verfahren zur Durchführung von Präparation und NMR-Messung von Proben mit einem Pipettiersystem und einem NMR-Spektrometer.

Es sind Injektions-NMR-Meßsysteme bekannt, bei denen das das Handhabungsgerät darstellende Pipettiersystem als Probenwechsler für das Spektrometer verwendet wird. Im Routinebetrieb des Handhabungsgerätes ist es unumgänglich, die. Sauberkeit einer Flußzelle, in der die spektroskopische Messung erfolgt, nach jeder Messung zu überprüfen. Hierzu wird, nach dem der FID (Free Induction Decay) (freier Induktionszerfall) der jeweils auszumessenden Probe aufgenommen und die Flußzelle gespült worden ist, auch ein FID der gespülten Flußzelle aufgenommen. Dieses aufgenommene Spektrum wird mit einem Referenzspektrum des jeweils verwendeten Lösemittel verglichen. Tauchen im sogenannten Clean-Spektrum gleich viel oder wenige Signale im Vergleich zum Referenzspektrum auf, so ist die Flußzelle garantiert sauber und es kann die Injektion der nächsten Probe in die Flußzelle erfolgen. Finden sich im gemessenen Clean-Spektrum mehr Signale als im Referenzspektrum, so muß die Flußzelle erneut gespült werden.

Im Verlauf der Bearbeitung einer Probe müssen verschiedene Arbeitsschritte durchgeführt werden. Seitens des Handhabungsgerätes muß die Präparation der Probe und die Injektion derselben in die Probenschleife, die Beförderung der Probe aus der Probenschleife in die Flußzelle, in der die Messung stattfindet sowie das Reinigen der Nadel und das Spülen der Flußzelle erfolgen. Im Spektrometer wird ein FID der Probe sowie ein FID der leeren, gespülten Flußzelle aufgenommen. Würde man die einzelnen Arbeitsschritte hintereinander ausführen, würde die benötigte Zeitspanne zur Bearbeitung einer Probe im Falle des Lösemittels Chloroform 375s betragen, im Falle einer Verwendung von DMSO würde die benötigte Zeitspanne 420s betragen.

Die benötigten Zeitspannen für die Bearbeitung einer jeweiligen Probe lassen eine solcherart beschaffene Auswertung als nicht wirtschaftlich erscheinen. Der Einsatz des Handhabungsgeräts lediglich als sequentiell eingesetzten Probenwechsel für Spektrometer ist angesichts der gebundenen Investitionskosten unwirtschaftlich und stellt eine hohe Kapitalbindung dar.

Aus der US-A-5 397 989 ist eine Vorrichtung zur Präparation und Durchführung von NMR-Messungen an Substratproben bekannt, wobei ein Pipettiersystem zur Herstellung der Substratproben und eine Flusszelle zur Präparation und Durchführung von NMR-Messungen vorgesehen sind, sowie eine Spülvorrichtung zur Spülung einer Zuführvorrichtung sowie des Pipettiersystems mit einem Lösungsmittel. Ausserdem existiert ein Computer, der mittels eines Netzwerkkables an eine NMR-Konsole und an einen 'autosampler' angeschlossen ist. Das Dokument offenbart weiterhin das gleichzeitige Laden einer Probe vom Probenbehälter und die Entfernung von Restflüssigkeit aus dem Probenkopf, d.h. es laufen mehrere Arbeitsschritte gleichzeitig ab.

Der Erfindung liegt angesichts der aufgezeigten Nachteile die Aufgabe zugrunde, eine bessere Ausnutzung der Hardware-Komponenten eines NMR-Meßsystems, bestehend aus einem Pipettiersystem und einer Flußzelle zur Auswertung enthaltenden Spektrometers zu erreichen.

Erfindungsgemäß wird die Aufgabe mit einem Verfahren gemäß Anspruch 1 gelöst.

Die mit dem erfindungsgemäß vorgeschlagenen Verfahren erzielbaren Vorteile beim Betrieb eines NMR-Meßsystems sind vor allem darin zu erblicken, daß nun die Möglichkeit besteht, Präparationsvorgänge wie das Lösen der Probe, das Mixen sowie das Verdünnen der Probe zeitgleich mit der Aufnahme der Meßdaten der jeweils vorhergehenden Probe, die sich bereits im Spektrometer befindet, durchzuführen. Analoges gilt für die notwendigen Spülvorgänge der Nadel und des Injektorportes, sobald eine neue Probe zur Spektroskopiemessung in der Flußzelle vorbereitet wird.

Durch eine zeitliche Verschachtelung und einer daraus resultierenden Parallelbearbeitung verschiedener Probensamples läßt sich beispielsweise für eine in Chloroform gelöste Probe die Bearbeitungszeit um bis zu 25% senken. Wird hingegen eine in Lösungsmittel DMSO gelöste Probe mittels des erfindungsgemäß vorgeschlagenen Verfahrens präpariert und einer Messung unterzogen, so läßt sich die Bearbeitungszeit von 420s auf 340s senken, was einer Senkung um etwa 20% entspricht.

Ferner läßt sich mittels des vorgeschlagenen Verfahrens bei dem zur Reinigung der Flußzelle von Rückständen der vorhergehenden Proben der Verbrauch von deuteriertem Lösemittel auf 3000 µl senken. Der Verbrauch an protoniertem Lösemittel beträgt 3000 µl.

Gemäß weiteren Ausgestaltungen des der Erfindung zugrundeliegenden Gedankens wird der Präparationsschritt des Lösens einer weiteren Probe in der Zuführvorrichtung zeitgleich mit der Aufnahme der Meßdaten im Spektrometer durchgeführt. Weiterhin werden die Spülvorgänge von Zuführeinrichtung und Injektorport am Pipettiersystem gleichzeitig mit der Auswertung der vorhergehenden Probe im Spektrometer des NMR-Meßsystems durchgeführt. Diese zeitlich geschachtelte Vorgehensweise erlaubt einen Parallelbetrieb von Spektrometer, der Zuführvorrichtung sowie der Pumpe, so daß die Hardware-Komponenten eines solcherart betriebenen NMR-Meßsystems gleichmäßiger ausgelastet sind.

Gemäß einer Weiterbildung des erfindungsgemäß vorgeschlagenen Verfahrens zum Betreiben eines NMR-Meßsystems wird vor einer Neuinjektion einer weiteren Substratprobe in die Flußzelle ein Spektrum der gespülten Flußzelle aufgenommen, welches mit einem Referenzspektrum des verwendeten Lösemittels verglichen wird. Auf diese Weise wird sichergestellt, daß nach einem Spülvorgang der Flußzelle keine Reste der in einem vorhergehenden Verfahrensschritt ausgemessenen Probe mehr in der Flußzelle enthalten sind und das Meßergebnis der neuen Probe verfälschen. Weiterhin wird bei Übereinstimmung der Spektren der gespülten Flußzelle mit dem Referenzspektrum eine Neueinspritzung einer nachfolgenden Probe vorgenommen und bei Divergenz der Spektren von gespülter Flußzelle und Referenzspektrum der Flußzelle ein weiteres Spülen der Flußzelle initiiert. Mit dieser Vorgehensweise ist sichergestellt, daß Reste vorhergehender Proben durch abhängig vom Vergleichsergebnis vorgenommene Spülvorgänge der Flußzelle vollständig aus dieser entfernt werden und nachfolgende Messungen nicht beeinträchtigen.

Zur Verschachtelung der einzelnen an Pipettiersystem und Spektrometer vorzunehmenden Bearbeitungsschritte von Proben, greifen der das Pipettiersystem samt Handhabungsgerät steuernde PC und die die NMR-Spektren auswertende Workstation auf einen gemeinsamen Verzeichnisbaum zu, der sowohl Probendateien als auch Steuerdateien (Flag Files) enthält. Durch die Verteilung der Steuerdateien innerhalb des Verzeichnisbaumes ist eine Indentifizierung und genauere Produzierbarkeit der erfolgten und noch zu erfolgenden Bearbeitungsschritte bei der Ausmessung einer Vielzahl von Proben gewährleistet.

Gemäß einer weiteren Ausgestaltungsform des erfindungsgemäß vorgeschlagenen Verfahrens können die Lösungsmittel, beispielsweise DMSO-d₆ und CDCl₃ in jeweils separaten, geschlossenen Kreisläufen in einem Pipettiersystem umgepumpt werden, wobei jedem geschlossenen Lösungsmittelkreislauf ein eigenes Pumpenmodul zugeordnet werden kann. Mittels dieser Ausführungsvariante des erfindungsgemäß vorgeschlagenen Verfahrens sind die sich einstellenden Lösungsmittelverluste gleich Null, so daß in einer Wirtschaftlichkeitsbetrachtung des Verfahrens Kosten für eine Ergänzung von Lösemittelschwund nunmehr auszuschließen ist. Als Lösungsmittel können bei dem erfindungsgemäß vorgeschlagenen Verfahren zum Betreiben eines NMR-Meßsystems vorzugsweise deuterierte Lösemittel wie etwa CDCl₃ oder DMSO-d₆ eingesetzt werden.

Weiterhin wird gemäß der vorliegenden Erfindung eine Vorrichtung gemäß Anspruch 8 vorgeschlagen.

Mittels Probendecks ist es möglich, bis zu 396 Substratproben mit einem Flaschenbodendurchmesser von 22 mm und einer Flaschenhöhe von 50 mm in einem Arbeitsgang zu bearbeiten; die jeweiligen Decks, in denen die Substratproben aufgenommen sind können zwei und mehr Etagen enthalten, auf welche die Zuführeinrichtung des Pipettiersystems zugreifen kann. Dadurch sind bedienerseitig keine Vorbereitungsmaßnahmen zu treffen, lediglich nach Abarbeitung eines Decks mit Substratproben ist dieses durch ein mit neuen Substratproben bestimmtes Deck zu ersetzen, was übrigens auch über ein vollautomatisches Beschickungssystem erfolgen kann, welches mit dem Pipettiersystem zusammenarbeitet.

Gemäß einer vorteilhaften Weiterbildung der erfindungsgemäß vorgeschlagenen Vorrichtung ist zur Verkürzung der Injektionszeiten der Proben sowohl in die Probenschleife als auch in die Flußzelle des Spektrometers einer HPLC-Pumpe mit einer Überdruckregelung vorgesehen. Die Überdruckregelung verhindert ein zu starkes Ansteigen des Druckes und damit eine Beschädigung der im Pipettiersystem vorhandenen Leitungs- und Ventilkomponenten.

Dem Pumpenmodul, welches im Pipettiersystem des NMR-Meßsystems enthalten ist, sind den verwendeten Lösungsmitteln - beispielsweise Chloroform oder DMSO-d₆ - entsprechende Bremskapillaren nachgeordnet, die je nach verwendetem Lösungsmittel einen unterschiedlichen Durchmesser oder eine unterschiedliche Länge aufweisen können. Damit kann den unterschiedlichen Viskositäten und Fließverhalten der verwendeten Lösungsmitteln, in welchen die Proben gelöst sind, Rechnung getragen werden.

Gemäß einer weiteren vorteilhaften Weiterbildung der erfindungsgemäß vorgeschlagenen Vorrichtung sind die Probendecks mindestens in zwei Etagen aufgeteilt, wobei in die einzelnen Probedecks die Substratbehälter eingelassen sind und zwischen den Decks Durchtrittsöffnungen für ein Durchgreifen der Zuführeinrichtung vorgesehen sind, so daß Zugriff auf die in den unteren Decks enthaltenen Substratproben gewährleistet ist.

Bei der erfindungsgemäß vorgeschlagenen Vorrichtung sind ferner Spülstationen für das Innere sowie das Äußere der Zuführeinrichtungen vorgesehen, durch welche ein applizierbarer Lösungsmittelfluß initiiert werden kann, so daß neben einer Reinigung der Flußzelle auch eine Reinigung der Zuführeinrichtung bei Wechsel des Substratprobenmaterials gewährleistet ist. Durch eine erfolgte Modifizierung der Spülstation kann die zur Präparation verwendete Nadel sowohl mit deuteriertem Lösemittel gereinigt, als auch mit protoniertem Lösemittel abgespritzt werden. Durch ein Reinigen der Zuführeinrichtung, die beispielsweise als eine stählerne Nadel mit einer winzigen Öffnung ausgebildet sein kann, ist gewährleistet, daß eine weitere Substratprobe nicht durch Reste einer vorhergehenden Substratprobe an der Zuführeinrichtung verunreinigt wird, wodurch das in der Fußzelle zu messende Spektrum erheblich beeinträchtigt werden würde.

An der das jeweilige Probensubstrat aufnehmenden Nadel kann in einer weiteren Ausgestaltungsform der vorliegenden Erfindung ein abstreifbares Einwegfilterelement aufgenommen sein, welches sich im Rahmen einer Vertikalbewegung der Zuführeinrichtung durch eine schlitzförmige Öffnung während der Aufwärtsbewegung der Zuführeinrichtung von der Spitze der Zuführeinrichtung, die als Nadel ausgebildet ist, entfernen läßt.

Schließlich können die Lösungsmittel, wobei es sich vorzugsweise um deuterierte Lösungsmittel wie Chloroform oder DMSO-d₆ handelt, jeweils in geschlossenen Lösemittelkreisläufen umlaufen, denen jeweils ein Pumpenmodul zugeordnet ist, welches die Lösungsmittel lösungsmittelspezifisch unterschiedlich lang bemessenen Bremskapillaren zuführt. Durch die Separierung der Lösemittelkreisläufe voneinander ist einerseits eine spezifische Behandlung des Lösemittels im Hinblick auf dessen Viskosität durch Auslegung der Bremskapillare möglich, andererseits lassen sich durch, die mit jeweils separaten Pumpenmodulen ausgestatteten geschlossenen Lösemittelkreisläufen, die Lösemittelverluste innerhalb der Pumpkreisläufe, wie z.B. durch Spülen auf Null reduzieren, so daß die laufenden Kosten in Bezug auf eine Ergänzung der Lösungsmittelverluste bei einem solcherart beschaffenen Pipettiersystem gegen Null gehen.

Anhand einer Zeichnung wird die Erfindung nachstehend noch detaillierter erläutert.

Es zeigt:
- **Figur 1**: den schematischen Aufbau eines Pipettiersystems samt Probendeck, Flußzelle sowie die Leitungssysteme verbindenden Ventile V₀, V₁, V₂ und V₃,
- **Figur 2**: die zeitliche Schachtelung der Arbeitsabläufe von Pipettiernadel, Pumpenmodul und Spektrometer bei der Bearbeitung zweier aufeinanderfolgenden Substratproben,
- Figur 3: eine gemeinsame Verzeichnisstruktur zur Kommunikation zwischen Pipettiersystem steuerndem Rechner und Akquisitionsrechner zur Auswertung der NMR-Spektren,
- **Figur 4**: eine detaillierte Darstellung der verwendeten Nadel,
- **Figuren 5.1-5.4**: detaillierte Darstellungen der jeweils verwendeten Ventile V₀, V₁, V₂ und V₃, die verschiedene Bereiche des Pipettiersystems miteinander verbinden,
- **Figuren 6.1-6.3**: Spülpositionen der zur Präparation verwendeten Nadel, 6.1 und 6.2 kommerziell erhältliche, 6.3 die modifizierte Spülstation,
- **Figur 7**: die Darstellung einer angeschrägten Nadel mit aufgesetztem Einwegfiltersystem,
- **Figur 8**: eine Abstreifstation für die Filterspitze gemäß Figur 7 für die Position des Filters an der Nadel (1), die Position der Nadel in der Abwurfstation (2) und die abgestreifte Filterspitze (3) und
- **Figur 9**: ein Pipettiersystem mit voneinander separierten Pumpenkreisläufen für ein Lösungsmittelumlauf innerhalb des Meßsystems ohne Lösungsmittelverluste, und
- **Figur 10**: zwei Pumpenkreisläufe mit zwei parallel ausgelegten Kolbenpumpen.

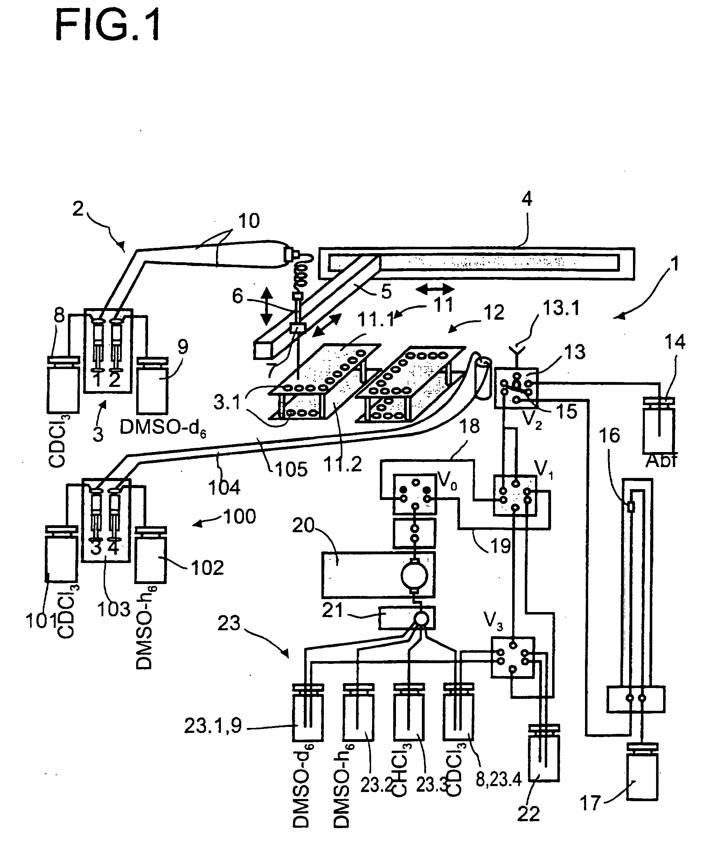

In der Darstellung gemäß Figur 1 ist der schematische Aufbau eines Pipettiersystems samt Substratprobendeck, Flußzelle sowie die Leitungssystemabschnitte jeweils verbindenden Ventile V₀, V₁, V₂ und V₃ wiedergegeben.

Das Pipettiersystem 1 gemäß der Darstellung in Figur 1 enthält.ein Grundgerüst 2 sowie ein Pumpenmodul 3. Am Grundgerüst 2 ist ein Roboterarm 4 vorgesehen, an dem ein weiterer Roboterarm 5 aufgenommen ist, der in Y-Richtung verfahrbar ist. Am Roboterarm 5 ist eine Zuführvorrichtung für die Substratproben vorgesehen, welche am Roboterarm 5 in Richtung des eingezeichneten Doppelpfeiles 6 in Z-Richtung auf- und abbewegbar ist. Der Nadelkopf der Zuführvorrichtung 7 steht über zwei Zuleitungen 10 mit zwei Lösungsbehältern 8, 9 in Verbindung. Im Lösungsmittelbehälter 8 ist CDCl₃ bevorratet, während im Lösungsmittelbehälter 9 das Lösungsmittel DMSO-d₆ bevorratet wird.

Über die Zuleitungen 10 kann die Zuführeinrichtung 7, die am Roboterarm 5 verfahrbar aufgenommen ist, mit jeweils einem der bevorrateten Lösungsmittel versorgt werden.

Unterhalb des Roboterarmes 5, an dem der Nadelkopf der Zuführeinrichtung 7 in Y-Richtung verfahrbar aufgenommen ist, sind Probendecks 11 bzw. 12 dargestellt. In der Darstellung gemäß Figur 1 enthalten das Probendeck 11 beispielsweise zwei Etagen 11.1 und 11.2, wobei die einzelnen Probendecks 11 bzw. 12 die Probengefäße 3.1 oder die Mikrotiter-Plättchen aufnehmen können, auch mehrere Etagen als die in Figur 1 wiedergegebenen zwei Etagen aufweisen. Um einen leichteren Zugriff auf die jeweils untere Etage 11.2 und den dort aufgenommenen Substratproben 3.1 zu gewährleisten, kann die obere Etage 11.1 des Probendecks 11 mit Durchtrittsöffnungen für die Zuführeinrichtung 7 zur Aufnahme der Substratproben 3.1 versehen werden. Anstelle der hier dargestellten zwei Probendecks 11 und 12, jeweils zwei Etagen umfassend, können auch weitere Probendecks übereinander oder nebeneinander aufgenommen sein, auf welche je nach Dimensionierung der Roboterarme 4 bzw. 5 des Pipettiersystems 1 automatisch zugegriffen werden kann.

Die durch die Zuführeinrichtung 7 jeweils aufgenommene Probe 3.1 wird in einen Einfülltrichter 13.1 an einem Injektorport in das Leitungssystem des Pipettiersystems 1 eingeführt. Der Injektorport 13 ist an das Ventil V₂ angeschlossen, wobei das Pumpensystem 3 drei weitere Ventile V₃, V₁ und V₀ enthält. Die Funktion der vier im Pipettiersystem aufgenommenen Ventile wird anhand der Figurenabfolge 5.1 bis 5.4 nachfolgend detaillierter beschrieben. Das Pumpensystem gemäß Figur 1 umfaßt ein Pumpenmodul 20, in dem eine HPLC-Pumpe aufgenommen ist, der einer Überdruckregelung nachgeordnet ist und über welche das erste Ventil V₀ beaufschlagt wird. Dem ersten Ventil V₀ sind zwei Bremskapillare 18 bzw. 19 nachgeordnet. Die Bremskapillare 18 dient zum Aufbau von Gegendruck für die HPLC-Pumpe, damit diese ihren minimalen Arbeitsgegedruck erhält und ist mit einem Eingangsport des nachgeschalteten Ventils V₁ verbunden, während die weitere Bremskapillare 19 für das Lösungsmittel DMSO dient und mit einem anderen Eingang des dem Ventil V₀ nachgeschalteten Ventil V₁ verbunden ist. An die Bremskapillare 18 bzw. 19 kann auch je eine HPLC-Pumpe angeschlossen sein, um Lösungsmittelrückvermischung im Betrieb zu minimieren.

Dem Pumpenmodul 20 ist ein Lösungsmittelwechsel 21 vorgeschaltet. Der Lösungsmittelwechsel 21 vermag auf verschiedene Lösungsmittelbehälter 23 zuzugreifen, die im einzelnen mit den Bezugszeichen 23.1, 23.2, 23.3 sowie 23.4 bezeichnet sind. Dabei enthält der mit 23.1 bezeichnete Lösungsmittelbehälter das bereits genannte Lösungsmittel DMSO-d₆ und entspricht somit dem Lösungsmittelbehälter 9 gemäß Figur 1, während der Lösungsmittelbehälter mit Bezugszeichen 23.4 dem Lösungsmittelbehälter 8 entspricht, in dem Chloroform aufgenommen ist. Der Lösungsmittelbehälter 23.2, auf den mittels des Lösungsmittelwechslers 21 zugegriffen werden kann, enthält DMSO-d₆, während der Lösungsmittelbehälter 23.3 das Lösungsmittel CHCl₃ aufnimmt. Bei Auslegung mit zwei HPLC-Pumpen wird der Verteiler 21 nicht benötigt.

Vom Injektorport 13 bzw. Ventil V₂ erstreckt sich die Zuführleitung für das in einem der Lösungsmittel 8, 9 gelöste Substratprobenmaterial zur Flußzelle 16. Die Flußzelle 16 ist in einem Probenkopf aufgenommen, beispielsweise INOVA 400 und hat ein Volumen von 120µl. Sie ist mit einer Zuführkapillare von PEEK 125µm bzw. Teflon 180 µm Innendurchmesser versehen, während eine 300µm Teflonkapillare mit der Flußzelle 16, in dem die NMR-Messung innerhalb des Spektrometers erfolgt, als deren Ableitung verbunden ist. Dem Auslaß der Flußzelle 16 ist ein Abfallbehälter 17 nachgeordnet, wobei dem Injektorport 13 bzw. dem Ventil V₂ ein weiterer Abfallbehälter 14 zugeordnet sein kann. Der Vollständigkeit halber sei erwähnt, daß dem Ventil V₃ neben den Zu- bzw. Ableitungen zu den Lösungsmittelbehältem 23 ebenfalls ein Abfallbehälter 22 zugeordnet sein kann.

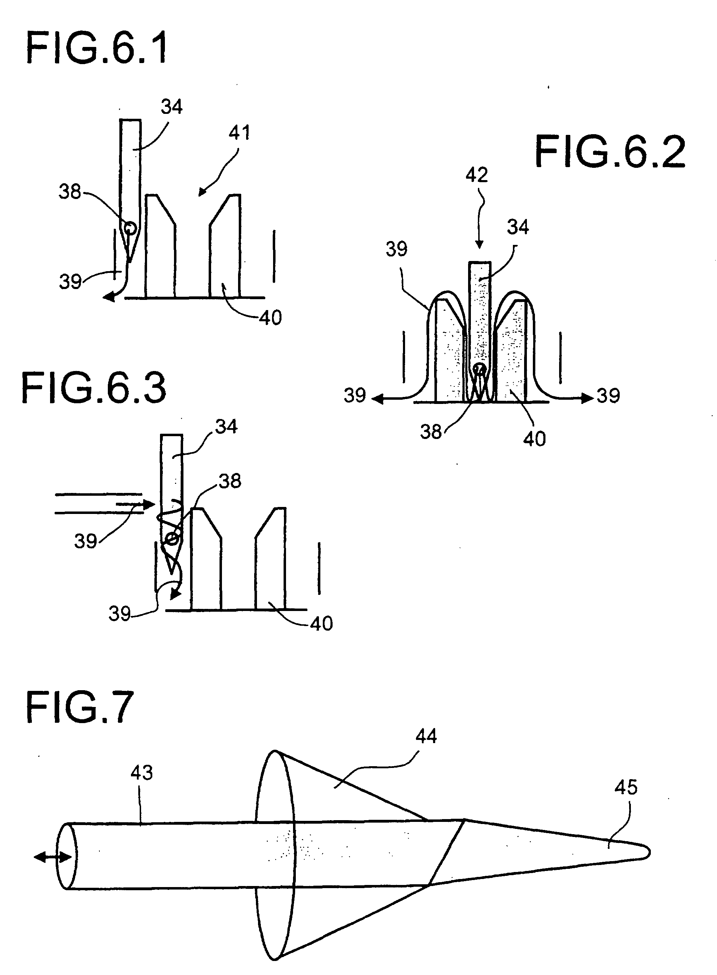

Die modifizierte Spülstation (vgl. Fig. 6.3) ist mit einem Pumpsystem 103 über zwei Kapillare 104 und 105 verbunden, durch welche protoniertes Lösemittel, in diesem Falle CHCl₃ und DMSO-h₆, aus den beiden Reservoirs 101 und 102 gefördert werden kann.

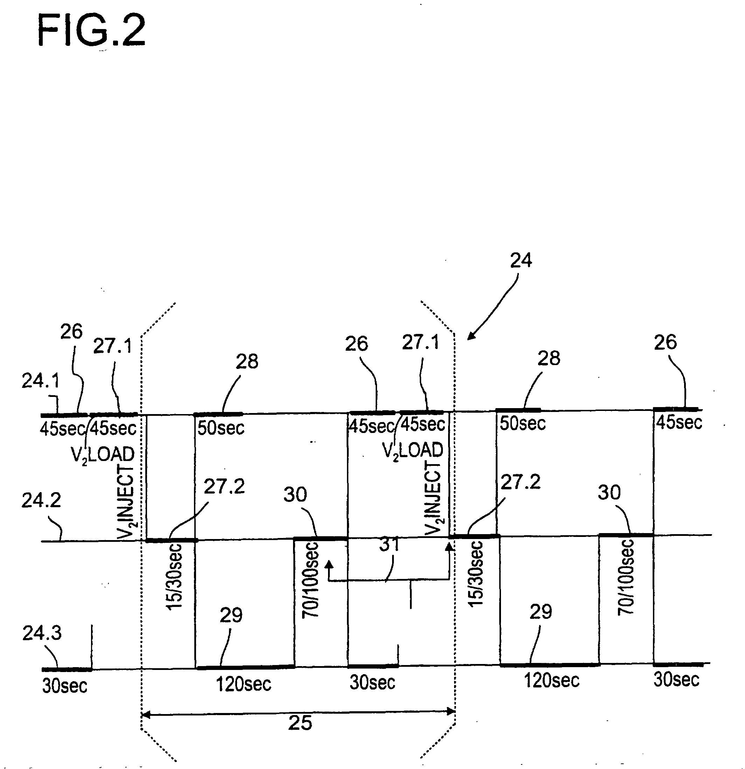

In der Darstellung gemäß Figur 2 ist die zeitliche Schachtelung der Arbeitsabläufe von Pipettiemadel, Pumpenmodul und die Flußzelle enthaltendem Spektrometer bei der Bearbeitung zweier aufeinander folgender Proben dargestellt.

Die Zeitabläufe, die die jeweils durchzuführenden Arbeitsschritte bei der Bearbeitung von Substratproben 3.1 erfordern, sind anhand von drei Zeitachsen 24.1, 24.2 bzw. 24.3 dargestellt. Auf der Zeitachse 24.1 sind die Bearbeitungsschritte, die mittels der Zuführeinrichtung 7 durchgeführt werden, dargestellt, während auf der Zeitachse 24.3 die Bearbeitungsschritte des Pumpsystem 3 wiedergegeben sind. Auf der Zeitachse gemäß 24.3 sind die im Spektrometer ablaufenden Bearbeitungsschritte wie Aufnahme des FID der Substratproben sowie Aufnahme eines FID's der mit Lösemittel gefüllten Flußzelle dargestellt. Mit Bezugszeichen 25 ist die Bearbeitungsspanne für die komplette Bearbeitung einer Substratprobe 3.1 dargestellt, die bei Verwendung des Lösungsmittels Chloroform 295s beträgt, während die Zeitspanne für die Bearbeitung einer in DMSO-d₆ gelösten Probe 340s beträgt.

Zu Beginn einer Probenüberarbeitung erfolgt eine Präparation und Verdünnung der ersten Probe, während der Zeitspanne 26, die etwa 45s beträgt. Daran schließt sich der Injektions-Bearbeitungsschritt 27.1 an, mit dem die vorbereitete, d.h. gelöste, gemixte und verdünnte Probe in eine Probenschleife 15 des Ventil V₂ eingespritzt wird. Die solcherart vorbereitete Probe wird innerhalb des weiteren Bearbeitungsschrittes 27.1, welcher 45s dauert, in die Probenschleife 15 des Injektorports 13 eingespritzt. Anschließend wird gemäß der Zeitachse 24.2 über die Zeitspanne 27.2 das Pumpenmodul angesteuert, so daß während einer Zeitspanne von 15 bzw. 30s - je nach gewähltem Lösungsmittel - die Probe in das Spektrometer 24.3 eingespritzt wird. Während der Zeitspanne 29, aufgetragen auf der unteren Zeitachse 24.3 für das Spektrometer, befindet sich die zu messende Substratprobe 3.1 120s entsprechend der Zeitspanne 29 in der Flußzelle 16 des Spektrometers. Parallel dazu wird gemäß der Zeitachse 24.1 eine Spülung der Zuführeinrichtung 7, d.h. der Zufühmadel und des Injektorports vorgenommen, die etwa 50s beansprucht, bezeichnet mit Bezugszeichen 28. Somit laufen die Vorgänge 28 und 29 in verschiedenen Hardware-Komponenten des NMR-Meßsystems zeitgleich miteinander ab. Nach Abschluß der Spektrumsaufnahme 29, die 120s in Anspruch nimmt, erfolgt ein Spülvorgang 30 der Flußzelle 16. Dazu wird Lösungsmittel in die Flußzelle 16 gepumpt, wozu das Pumpenmodul 20 während einer Zeitspanne von 70 bzw. 100s - je nach verwendetem Spülmittel - beaufschlagt wird. Im Spektrometer 24.3 schließt sich daraufhin die Aufnahme eines Clean-Spektrums an, welche 30s Zeit benötigt, während der ein Spektrum der gespülten Flußzelle 16 aufgenommen wird. Parallel dazu wird gemäß der Zeitachse 24.1 eine nachfolgende Probe in der Zuführvorrichtung gemäß der Bearbeitungsschritte 26 präpariert und verdünnt, sowie gemäß des Bearbeitungsschritts 27.1 durch die Zuführvorrichtung 7 in eine Pumpenschleife 15 des Injektorsports 13 eingespritzt. Danach schließt sich analog zum bereits dargestellten Bearbeitungszyklus eine Einspritzphase 27.2 durch das Pumpenmodul 20 an, während der ein Einspritzen des Probenvorrates in das Spektrometer 24.3 und dessen Meßwertaufnahme während der Zeitspanne 29 erfolgt.

Abhängig vom Ergebnis des Clean-Spektrums der gespülten Flußzelle 16, welche 30s benötigt, erfolgt ein Vergleich des Spektrums der gespülten Flußzelle 16 mit deren Referenzspektrum. Abhängig vom Ergebnis des Vergleichs 31 von Referenzspektrum und Clean-Spektrum wird ein Einspritzen 27.2 der parallel vorbereiteten nachfolgenden Probe in die gespülte und für in Ordnung befundene Flußzelle 16 initiiert. Ergibt das Vergleichsergebnis 31 hingegen eine Divergenz zwischen Referenzspektrum des verwendeten Lösemittels und aufgenommenem Clean-Spektrum der Flußzelle 16, so erfolgt ein erneuter Spülvorgang der Flußzelle 16, der mit Bezugszeichen 30 bezeichnet ist. Wie bereits erwähnt, beträgt die Zeitspanne für alle Arbeitsschritte für eine Chloroform-gelöste Probe etwa 295s, während die Bearbeitungszeit einer in DMSO-d₆ gelösten Probe etwa 340s in Anspruch nimmt.

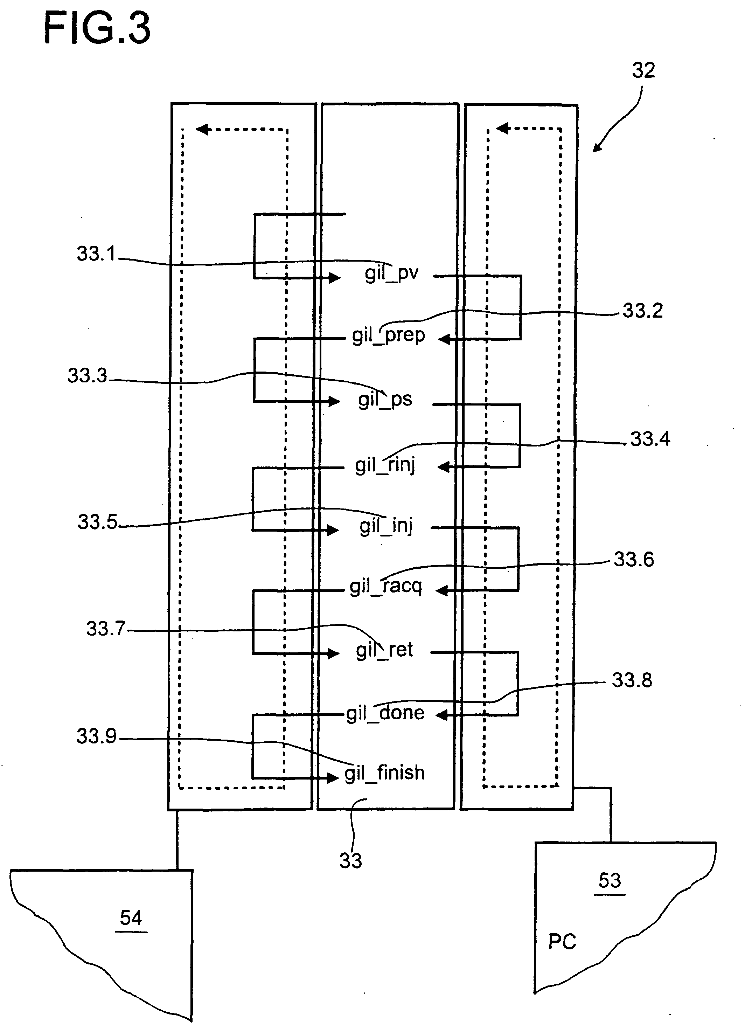

In der Darstellung gemäß Figur 3 ist eine gemeinsame Verzeichnisstruktur zur Kommunikation zwischen dem Pipettiersystem steuernden PC und eine Akquisitionsrechner, beispielsweise einer SUN-Workstation dargestellt.

Der gemeinsame Verzeichnisbaum 32, auf den die Recheneinheiten 53 bzw. 54 gemeinsam zugreifen können, enthält Verzeichnisse 33. Der gemeinsame Verzeichnisbaum wird von den beiden PC's in einer Endlosschlaufe laufend nach auftauchenden Flag-files durchsucht. Mit 33.1 ist ein Verzeichnis der Probendateien bezeichnet, die zur Bearbeitung und Messung anstehen. Mit Bezugszeichen 33.2 ist das Verzeichnis zur Probenvorbereitung bezeichnet, während mit Belegung des Verzeichnisses 33.3 der Injektionsbefehl für die präparierte Substratprobe 3.1 in die Probenschleife 15 des Injektorports 13 gegeben wird. Belegung des Verzeichnisses 33.4 signalisiert die Bereitschaft des Systems zur Einspritzung einer neuen Probe, während mit Belegung des Verzeichnisses 33.5 der Befehl zur Injektion in die Flußzelle 16 bezeichnet ist. Die Belegung des Verzeichnisses 33.6 bezeichnet die Fertigmeldung zur Aufnahme der Meßdaten, welche durch das Spektrometer von der in der Flußzelle 16 enthaltenen, gelösten, präparierten Substratprobe 3.1 gemacht werden. Mit Belegung des Verzeichnisses 33.7 wird der Befehl zum Verwerfen einer Substratprobe bzw. zum Spülen der Flußzelle 16 bezeichnet. Unter 33.8 sind im Verzeichnisbaum 32 der Verzeichnisse 33 diejenigen Dateien abgelegt, welche nach Fertigstellung einer Probenmessung abgearbeitet werden müssen, während mit 33.9 das Verzeichnis bezeichnet ist, auf welches die beiden Rechner 53 bzw. 54 zugreifen können, in welchem die Dateien abgelegt sind, welche nach Abarbeitung eines vollständigen Probendurchlaufs zu durchlaufen sind.

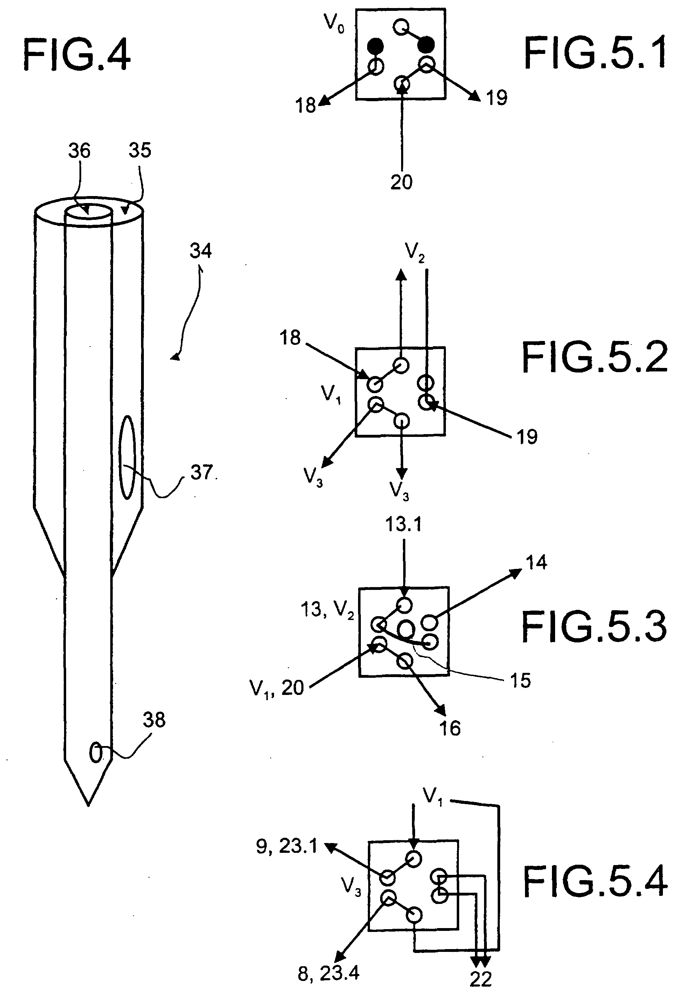

In Figur 4 ist eine detaillierte Darstellung einer einsetzbaren Zuführeinrichtung 7 dargestellt.

An einem Nadelkopf gemäß Figur 1, der in Z-Richtung 6 auf- und abbewegbar ist, kann beispielsweise eine gemäß der Darstellung in Figur 4 ausgebildete Nadel 34 aufgenommen sein. Die Nadel 34 enthält zwei Leitungskanäle, einen inneren Kanal 36 zur Zufuhr und Aufnahme eines Flüssigkeitsvolumens, sowie einen äußeren sich ringförmig um den inneren Kanal 36 erstreckenden Luftführungskanal 35. Der Luftführungskanal mündet in eine hier nur schematisch angedeutete Belüftungsöffnung 37. Der Kanal für die Flüssigkeitsführung 36 weist am Ende der Nadel 34 eine seitlich positionierte Ansaugöffnung 38 auf.

Aus den Darstellungen gemäß der Figuren 5.1 bis 5.4 geht eine detaillierte Wiedergabe der im Pipettiersystem vorgesehenen Ventile V₀, V₁, V₂ sowie V₃ hervor, mit welchen die Leitungen bzw. Behälter des Pipettiersystems untereinander verbunden werden können.

In Figur 5.1 ist das Ventil V₀, welches dem Pumpenmodul 20 und dessen Überdruckregelung nachgeordnet ist, näher dargestellt. Die Zuleitung vom Pumpenmodul ist mit Bezugszeichen 20 gekennzeichnet, während vom Ventil V₀ die beiden Bremskapillaren 18 bzw. 19 abzweigen. Die dunkel herausgezeichneten Punkte markieren Blindstopfen, die im Ventil V₀ vorgesehen sind. Wie bereits in Zusammenhang mit der Darstellung in Figur 1 erwähnt, sind die Bremskapillaren 18 bzw. 19 jeweils lösungsmittelspezifisch hinsichtlich Durchflußquerschnitt sowie Bremskapillarlänge ausgelegt.

In Figur 5.2 ist das Ventil V₁ des Pipettiersystems 1 detaillierter gezeigt. An den mit Bezugszeichen 18 bzw. 19 bezeichneten Eingängen des Ventils V₁ münden die bereits erwähnten Bremskapillaren 18 bzw. 19. Die beiden oberen Ausgänge des Ventils V₀ stellen Zuleitungen zum Ventil V₂ dar, während die beiden unteren Ausgänge des Ventils V₁ Zuleitungen zum Ventil V₃ darstellen.

Figur 5.3 zeigt das Ventil V₂ des Pipettiersystems 1, welches eine Probenschleife 15 enthält. Vom Ventil V₂ zweigt eine Leitung in den Abfallbehälter 14 mündend ab, während mit 13.1 der Zuführtrichter für die jeweils zuzuführende Substratprobe bezeichnet ist. Am unteren Ausgang des Ventils V₂ bzw. Injektorports 13 zweigt die Zuleitung zur Flußzelle 16 ab, während an dem mit V₁ bezeichneten Eingang des Injektorports 13 bzw. des Ventils V₂ die Zuleitung von Ventil V₁ kommend in das Ventil V₂ mündend.

Aus der Darstellung gemäß 5.4 gehen die Anschlußbezeichnungen der Ein- bzw. Ausgänge des Ventils V₃ näher hervor. Mit V₁ sind die beiden Zuleitungen, vom Ventil ₁ kommend, bezeichnet, während mit Bezugszeichen 22 die beiden Zuleitungen in einen Abfallbehälter 22 bezeichnet sind. Seitlich am Ventil V₃ erstrecken sich die Leitungen, die zu den verschiedenen Lösungsmittelbehältern führen, wobei die obere Leitung in den Behälter 9 bzw. 23.1 mündet, der DMSO-d₆ enthält, während der mit Bezugszeichen 8 bzw. 23.4 bezeichnete Ausgang des Ventils V₃ in das Lösungsmittel Chloroform als deuteriertes Lösungsmittel enthaltenden Behälter 8 mündet.

In den Figuren 6.2 bis 6.3 sind Spülpositionen der Zuführeinrichtung dargestellt, welche die Substratproben 3.1 aus den jeweiligen Mikrotiter-Trägern bzw. Flaschen der Probendecks entnimmt.

In Figur 6.1 ist eine Nadelinnenspülung 41 näher dargestellt. Die neben einer Spülstation 40 in eine Abtauchposition eingefahrene Nadel 34 wird über die in der Nadelspitze vorgesehene seitliche Öffnung 38 gespült, wodurch sich ein Lösungsmittelfluß 39 aus der Nadelspitze einstellt, wodurch das Innere der Nadel 34 gespült wird.

In Figur 6.2 ist eine Nadelaußenspülung 42 dargestellt, wobei die Nadel 34 in das Innere einer Spülstation 40 eintaucht. Durch den sich durch die Öffnung 38 einstellenden Spülmittelfluß steigt das Spülmittel an den Seiten der Spülstation 40 empor und reinigt somit nach erfolgter Reinigung der Innenflächen der Nadel 34 deren Außenfläche und fließt über die Außenfläche der Spülstation in ein Auffangbehältnis ab.

In Figur 6.3 ist ein seitlich einer Spülnadel 34 aufgeprägter Spülmittelfluß 39 dargestellt. Bei dieser Ausführungsvariante wird der Spülmittelfluß der Nadel 34 von außen aufgeprägt, wobei sich eine die Spitze der Nadel 34 schlangenförmig umgebende Spülmittelströmung einstellt, wodurch die Außenseite der Nadel gereinigt wird.

Mit den in den Figuren 6.1 bis 6.3 dargestellten Spülzyklen der jeweiligen Zuführeinrichtung 7, 34 lassen sich sowohl Lösemittelrückstände als auch Substratprobenrückstände aus der Zuführeinrichtung entfernen, so daß sichergestellt ist, daß eine Probenverschleppung von einem die Proben enthaltenden Behälter bei Probenwechsel zur nächsten Probe ausgeschlossen ist.

Figur 7 zeigt die Darstellung einer angeschrägten Nadel 43 mit aufgesetzter Einwegfilterspitze 44 bzw. 45.

Das Filterelement ist in den Einwegfilter in Gestalt einer Fritte aus Watte oder aus einem anderen porösen Werkstoff vorgesehen und haftet durch Reibung auf der Außenseite der angeschrägten Nadel 43. Der Flüssigkeitsvorrat einer Substratprobe, die im Inneren der Nadel 43 enthalten ist, wird durch das im Filterelement enthaltene Filterglied gefiltert und tritt an der Spitze des Filters 45 in gefiltertem Zustand aus. Der Filterabschnitt 44 bzw. 45 kann aus Papier oder Kunststoff beschaffen sein, wobei sein trichterförmig aufgeweiteter Bereich als Abstreifhilfe ausgebildet ist.

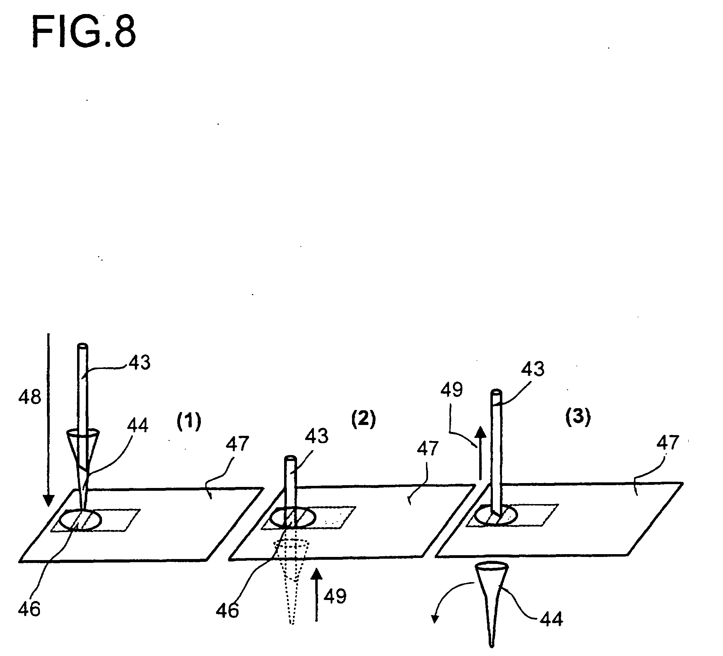

Gemäß der Figuren 8 (1), (2), (3) ist ein Abstreifzyklus eines Einwegfilterelementes von einer angeschrägten Nadel 43 dargestellt.

Aus dem Figurenzyklus geht hervor, daß durch den angeschrägt verlaufenden Filterbereich des Filterelements 44, 45 eine Eintauchbewegung einer mit einem solchen Filter versehenen Nadel mit Anschrägung durch einen Schlitz 46 eines Substratträgers möglich ist, wobei die Nadel in Richtung 48 in das Substrat 47 eintaucht. Bei der sich anschließenden Ausfahrbewegung liegt der trichterförmig sich erweiternde Bereich des Einwegfilters an der Unterseite des Schlitzes 46 des Substrates 47 an und bleibt bei der Ausfahrbewegung der Nadel 43 am Substrat hängen. Gemäß Figur 8 (3) fährt die angeschrägte Nadel 43 in Ausfahrrichtung 49 aus dem Schlitz 46 des Substrates 47 aus, wobei das Einwegfilterelement 44, 45 an der Unterseite des Substrates verbleibt und in einen Abfallbehälter aufgenommen werden kann.

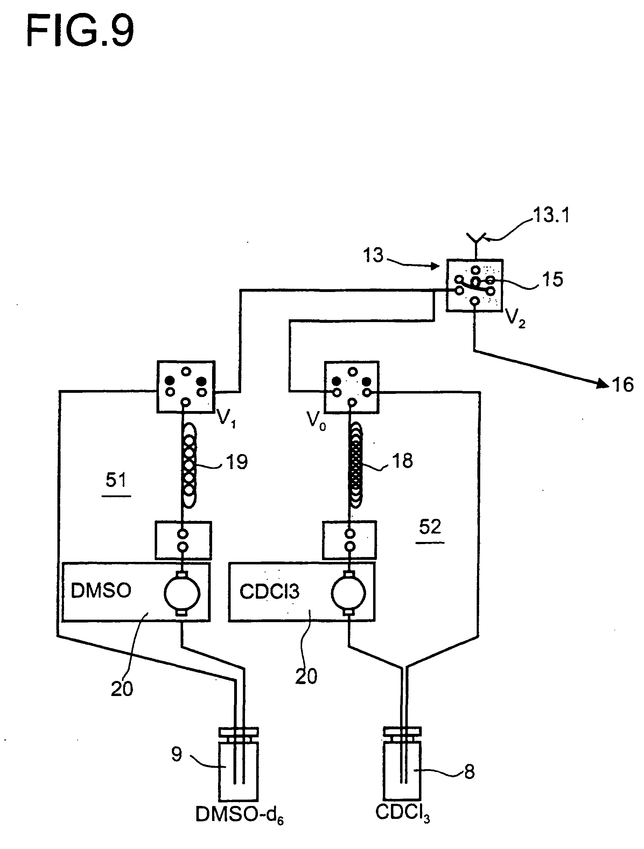

In Figur 9 ist eine alternative Ausgestaltung der Lösungsmittelbeförderung durch das Pipettiersystem gemäß Figur 1 wiedergegeben.

In dieser Konfiguration sind die Ventile V₀, V₁ sowie V₂ nach wie vor im Pipettiersystem enthalten, während jedoch für das Lösungsmittel DMSO ein geschlossener Kreislauf 51 sowie für das weitere Lösungsmittel - beispielsweise Chloroform - ebenfalls ein geschlossener Lösemittelkreislauf 52 vorgesehen ist. Im Kreislauf 51 für da Lösungsmittel DMSO ist eine Bremskapillare 19 spezifisch auf das Lösungsmittel abgestimmt vorgesehen. Das Pumpenmodul 20 ist mit dem entsprechenden Lösemittelbehälter 9 (vergl. Figur 1) für das Lösemittel DMSO-d₆ verbunden. Im geschlossenen Kreislauf 52, der ein separates Pumpenmodul 20 enthält, ist eine Bremskapillare 18 für das Lösungsmittel Chloroform vorgesehen, welches im Vergleich zur Bremskapillare 19 des geschlossenen Kreislaufs 51 eine größere Längenerstreckung - hier dargestellt durch eine höhere Anzahl von Bremswindungen - enthält. Im Lösungsmittelkreislauf 52 ist der Lösungsmittelbehälter 8 für das Chloroform eingebunden, welcher als Vorrat und als Ablauftank für das Chloroform dient. Von den jeweiligen Ventilen V₁ bzw. V₀ weisen Zuleitungen zum Ventil V₂ auf, welches dem Injektorport 13 entspricht, von dem aus die Flußzelle 16 mit einer Substratprobe 3.1 mit entsprechendem Lösemittel DMSO oder Chloroform präpariert zugeführt wird. Im Injektorport 13 ist darüber hinaus auch in dieser Ausführungsvariante des Pipettiersystems gemäß Figur 9 eine Probenschleife 15 enthalten sowie der Einlauftrichter 13.1 vorgesehen, über welchen die von der Zuführeinrichtung 7 aufgenommene Substratprobe dem Spektrometer 24.3 zugeführt wird.

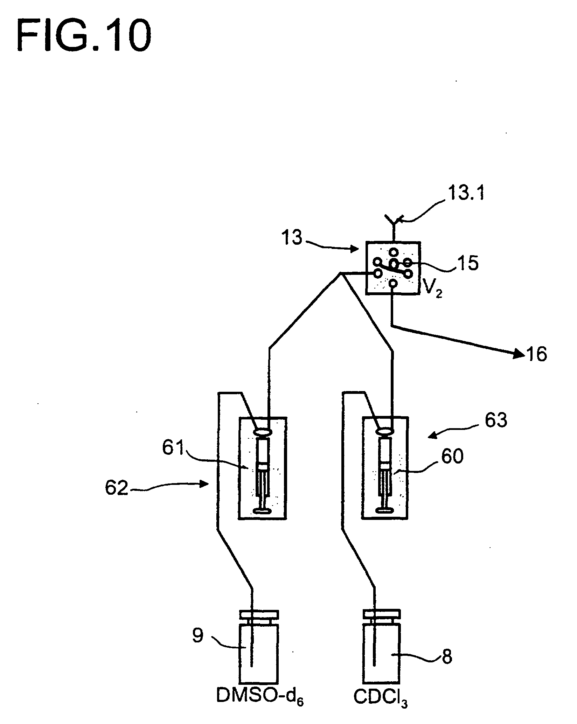

In Fig. 10 ist eine weitere denkbare Lösung dargestellt. Statt der wie in Fig. 9 beschriebenen zwei Pumpenkreisläufe, ist auch der Einsatz zweier parallel ausgelegter Kolbenpumpen 60 bzw. 61 denkbar. Auch hier erhält man eine parallele Ausführung der Lösemittelsysteme 62 bzw. 63. Ansonsten ähnelt die Konfiguration gemäß Fig. 10 im wesentlichen der in Fig. 9 wiedergegebenen Darstellung.

### Bezugszeichenliste

- 1: Pipettiersystem
- 2: Grundgerüst
- 3: Pumpmodul
- 3.1: Substratprobe
- 4: Robotearm
- 5: Roboterarm
- .6: Verfahrweg in Z-Richtung
- 7: Zuführvorrichtung
- 8: Lösemittelbehälter Chloroform
- 9: Lösemittelbehälter DMSO-d₆
- 10: Zuleitungen
- 11: Probendeck
- 11.1: erste Etage
- 11.2: zweite Etage
- 12: weiteres Probendeck
- 13: Injektorport
- 13.1: Einlauftrichter
- 14: Abfallbehälter
- 15: Probenschleife
- 16: Flußzelle für Spektralanalyse
- 17: Abfallbehälter
- 18: erste Bremskapillare
- 19: zweite Bremskapillare
- 20: Pumpenmodul
- 21: Lösemittelwechsel
- 22: Abfallbehälter
- 23: Lösungsmittelbehälter
- 23.1: Lösungsmittelbehälter
- 23.2: Lösungsmittelbehälter
- 23.3: Lösungsmittelbehälter
- 23.4: Lösungsmittelbehälter

- V₀: Ventil
- V₁: Ventil
- V₂: Ventil
- V₃: Ventil

- 24: Parallelabarbeitungsverlauf
- 24.1: Zeitachse Zuführeinrichtung
- 24.2: Zeitachse Pumpenmodul
- 24.3: Zeitachse Spektrometer, Spektrometer
- 25: Bearbeitungsspanne erste Probe
- 26: Präparationsphase
- 27: Injektion
- 27.1: Injektion Probenschleife
- 27.2: Injektion Flußzelle
- 28: Spülung Flußzelle
- 29: Aufnahmespektrum
- 30: Spülung Flußzelle
- 31: Vergleich Referenzspektrum Clean-Spektrum Flußzelle
- 32: Verzeichnisbaum
- 33: Verzeichnisdateien
- 33.1: Bereitstellungsverzeichnis
- 33.2: Präparationsverzeichnis
- 33.3: Injektionsfertigmeldung
- 33.4: Injektionsausführungsverzeichnis
- 33.5: Injektion Flußzelle
- 33.6: Verzeichnis Aufnahme Probenspektrum
- 33.7: Aufnahme Probenspektrum
- 33.8: Verzeichnis Spülung Flußzelle
- 33.9: Freigabe
- 34: Nadel
- 35: Luftführung
- 36: Flüssigkeitsführung
- 37: Belüftungsöffnung
- 38: seitliche Ansaugöffnung
- 39: Spülmittel
- 40: Spülstation
- 41: Nadelinnenspülung
- 42: Nadelaußenspülung
- 43: Nadel mit Einwegfilteraufsatz
- 44: Filterabschnitt
- 45: Filterspitze
- 46: Durchtrittsspalt
- 47: Substrat
- 48: Eintauchbewegung
- 49: Ausfahrbewegung
- 50: Ausfahrweg
- 51: erster geschlossener Lösemittelkreislauf
- 52: zweiter geschlossener Lösemittelkreislauf
- 53: Steuerung Pipettiersystem
- 54: Akquisitionsrechner (SUN-Workstation)

- 60: erste Kolbenpumpe
- 61: zweite Kolpenpumpe
- 62: erstes Pumpsystem
- 63: zweites Pumpsystem

- 100: modifizierte Spülstation mit Kapillarsystem
- 101: erstes Reservoir Spüllösemittel hier CHCl₃
- 102: zweites Reservoir Spüllösemittel hier DMSO-h₆
- 103: Pumpsystem
- 104: erste Zuleitung zu Spülstation
- 105: zweite Zuleitung zu Spülstation

## Patentansprüche

1. Verfahren zur Präparation und Durchführung von NMR-Messungen an Substratproben, wobei von den Proben (3) mittels eines Pipettiersystems (1) Lösungen hergestellt werden und einer Flußzelle (16) zur Präparation und Durchführung von NMR-Messungen in einem Spektrometer (24.3) zugeführt werden, wobei eine Zuführvorrichtung (7) sowie das Pipettiersystem (1) gegebenenfalls mit mindestens einem Lösungsmittel (8, 9) gespült werden, wobei ein die Aufnahme eines NMR-Spektrums der Probe (3.1) durchführende Akquisitionsrechner (54) und ein das Pipettiersystem (1) steuernder Rechner (53) auf einen gemeinsamen Verzeichnisbaum (32) zugreifen, der Verzeichnisse (33.1 bis 33.9) mit die Proben definierenden Dateien und Steuerdateien enthält, über deren Aufruf ein zeitlich geschachteltes Abarbeiten der Verzeichnisse (33.1 bis 33.9) und daraus resultierend eine Parallelbearbeitung verschiedener Substratproben erfolgt.

2. Verfahren gemäß Anspruch 1, **dadurch gekennzeichnet, daß** die Präparationsschritte Lösen und Verdünnen sowie Mixen einer ersten Substratprobe (3.1) an einer Zuführeinrichtung (7, 24.1) zeitgleich mit der Aufnahme (29) des Spektrums im Spektrometer (24.3) erfolgen.

3. Verfahren gemäß Anspruch 1, **dadurch gekennzeichnet, daß** Spülvorgänge (28) von Zuführeinrichtung (7) und Injektorport (13, 13.1) gleichzeitig mit der Aufnahme (29) des Spektrums einer vorhergehenden Substratprobe (3.1) im Spektrometer (24.3) erfolgen.

4. Verfahren gemäß Anspruch 1, **dadurch gekennzeichnet, daß** vor einer Neuinjektion (27.1) einer nachfolgend präparierten Substratprobe (3) in die Flußzelle (16) ein Spektrum der gespülten Flußzelle (16) aufgenommen wird, welches mit einem Referenzspektrum der Flußzelle (16) verglichen wird.

5. Verfahren gemäß Anspruch 4, **dadurch gekennzeichnet, daß** bei Übereinstimmung der Spektren der gespülten Flußzelle (16) mit dem Referenzspektrum eine Neueinspritzung einer nachfolgenden Substratprobe (3.1) in die Flußzelle (16) erfolgt und bei Divergenz der Spektren ein weiteres Spülen (30) der Flußzelle (16) initiiert wird.

6. Verfahren gemäß einem der vorhergehenden Ansprüche, **dadurch gekennzeichnet, daß** die Lösungsmittel (8, 9) in jeweils separaten, geschlossenen Kreisläufen (51, 52) im Pipettiersystem (1) umgepumpt werden und jedem Lösungsmittelkreislauf (51, 52) ein eigenes Pumpenmodul (20) zugeordnet ist.

7. Verfahren gemäß Anspruch 1, **dadurch gekennzeichnet, daß** als Lösungsmittel (8, 9, 23.1, 23.4) deuterierte Lösungsmittel Chloroform und DMSO-d₆ eingesetzt werden.

8. Vorrichtung zur Präparation und Durchführung von NMR-Messungen an Substratproben (3.1), wobei ein Pipettiersystem zur Herstellung der Substratproben (3.1) und eine Flußzelle (16) zur Präparation und Durchführung von NMR-Messungen vorgesehen sind, sowie mindestens eine Spülvorrichtung zur Spülung einer Zuführvorrichtung (7) sowie des Pipettiersystems (1) mit mindestens einem Lösungsmittel (8, 9), und wobei des weiteren ein Steuerungsrechner (53) für das Pipettiersystem (1) und ein Akquisitionsrechner (54) zur Aufnahme von NMR-Probenspektren vorgesehen sind, die auf einen Verzeichnisbaum (32) gemeinsam zugreifen, der die Proben (3.1) definierende Dateien und Steuerdateien in Verzeichnissen (33.1 bis 33.9) enthält, so daß eine Parallelbearbeitung verschiedener Substratproben erfolgt.

9. Vorrichtung gemäß Anspruch 8, **dadurch gekennzeichnet, daß** zur Verkürzung der Injektionszeiten (27.1, 27.2) der Proben in eine Probenschleife (15) ein HPLC-Pumpenmodul (20) mit Überdruckregelung eingesetzt wird.

10. Vorrichtung gemäß Anspruch 8, **dadurch gekennzeichnet, daß** dem Pumpenmodul (20) jeweils für eines der Lösungsmittel (8, 9) spezifische Bremskapillarstrecken (18, 19) nachgeschaltet sind.

11. Vorrichtung gemäß Anspruch 8, **dadurch gekennzeichnet, daß** die Substratproben (3.1) in Probendecks (11, 12) aufgenommen sind und daß die Probendecks (11, 12) mindestens zwei Etagen (11.1, 11.2) aufweisen, in welche Substratproben (3.1) aufnehmende Behälter eingelassen sind, wobei zwischen den Etagen (11.1, 11.2) Durchtrittsöffnungen für die Zuführeinrichtung (7) vorgesehen sind.

12. Vorrichtung gemäß Anspruch 8, **dadurch gekennzeichnet, daß** das ein Pipettiersystem eine Nadel (34) zur Probenaufnahme besitzt und daß eine Spülstation (40) für eine Nadelinnenspülung sowie eine Nadelaußenspülung der Nadel (34) mit einem zu applizierenden Lösungsmittelfluß (39) vorgesehen ist.

13. Vorrichtung gemäß Anspruch 8, **dadurch gekennzeichnet, daß** das ein Pipettiersystem eine Nadel (34) zur Probenaufnahme besitzt und daß an der die Substratprobe (3.1) aufnehmenden Nadel (34) ein bei einer Vertikalbewegung (49,50) der Zuführeinrichtung (7) abstreifbares Einwegfilterelement (44, 45) vorgesehen ist.

14. Vorrichtung gemäß Anspruch 8, **dadurch gekennzeichnet, daß** die Lösungsmittel (8, 9) jeweils in geschlossenen Lösungsmittelkreisläufen (51, 52) umlaufen, denen jeweils Pumpenmodule (20) sowie lösungsmittelspezifisch unterschiedlich bemessene Bremskapillaren (18, 19) zugeordnet sind.

## Claims

1. A process for preparing and carrying out NMR measurements on substrate samples, solutions of the samples (3) being prepared by means of a pipetting system (1) and being fed to a flow cell (16) for preparation and carrying out of NMR measurements in a spectrometer (24.3), and it being possible to flush a feed apparatus (7) and the pipetting system (1), if necessary, with at least one solvent (8, 9), an acquisition computer (54) recording an NMR spectrum of the sample (3.1) and a computer (53) controlling the pipetting system (1) accessing a common directory tree (32) which contains directories (33.1 to 33.9) with files which define the samples and with control files which are called up in such a way as to ensure that the directories (33.1 to 33.9) are worked through in a time-interleaved manner and consequently that different substrate samples are processed in parallel.

2. A process as claimed in claim 1, wherein the preparation steps of the solution and dilution as well as mixing of a first substrate sample (3.1) in a feed apparatus (7, 24.1) are carried out simultaneously with the recording (29) of the spectrum in the spectrometer (24.3).

3. A process as claimed in claim 1, wherein flushing procedures (28) for feed apparatus (7) and injector port (13, 13.1) are carried out simultaneously with the recording (29) of the spectrum of a preceding substrate sample (3.1) in the spectrometer (24.3).

4. A process as claimed in claim 1, wherein, before a fresh injection (27.1) of a subsequently prepared substrate sample (3) into the flow cell (16), a spectrum of the flushed flow cell (16) is recorded and is compared with a reference spectrum of the flow cell (16).

5. A process as claimed in claim 4, wherein, if the spectra of the flushed flow cell (16) correspond to the reference spectrum, a fresh injection of a subsequent substrate sample (3.1) into the flow cell (16) is effected and, in the event of divergence of the spectra, further flushing (30) of the flow cell (16) is initiated.

6. A process as claimed in one of the preceding claims, wherein the solvents (8, 9) are each pumped around in separate, closed circulations (51, 52) in the pipetting system (1) and a separate pump module (20) is coordinated with each solvent circulation (51, 52).

7. A process as claimed in claim 1, wherein the solvents (8, 9, 23.1, 23.4) used are deuterated solvents chloroform and DMSO-d₆.

8. An apparatus for preparing and carrying out NMR measurements on substrate samples (3.1), a pipetting system being provided for preparing the substrate samples (3.1) and a flow cell (16) being provided for preparing and carrying out NMR measurements, and also at least one flushing apparatus for flushing a feed apparatus (7) and also the pipetting system (1) with at least one solvent (8, 9), and, further, there being provided a control computer (53) for the pipetting system (1) and an acquisition computer (54) for recording NMR spectra of samples, these computers jointly accessing a directory tree (32) which contains files which define the samples (3.1) and contains control files in directories (33.1 to 33.9), so that different substrate samples are processed in parallel.

9. An apparatus as claimed in claim 8, wherein an HPLC pump module (20) having an excess pressure control is used for shortening the injection times (27.1, 27.2) of the samples into a sample loop (15).

10. An apparatus as claimed in claim 8, wherein brake capillary zones (18, 19) specific for each of the solvents (8, 9) are arranged downstream of the pump module (20).

11. An apparatus as claimed in claim 8, wherein the substrate samples (3.1) are held in sample decks (11, 12) and the sample decks (11, 12) have at least two levels (11.1, 11.2) into which containers holding substrate samples (3.1) are led, passages for the feed apparatus (7) being provided between the levels (11.1, 11.2).

12. An apparatus as claimed in claim 8, wherein the pipetting system has a needle (34) for taking samples and a flushing station (40) for flushing of the interior and the exterior of the needle (34) with a solvent flow (39) to be applied is provided.

13. An apparatus as claimed in claim 8, wherein the pipetting system has a needle (34) for taking samples and a disposable filter element (44, 45) which is wipable during a vertical movement (49, 50) of the feed apparatus (7) is provided on the needle (34) taking up the substrate sample (3.1).

14. An apparatus as claimed in claim 8, wherein the solvents (8, 9) each circulate in closed solvent circulations (51, 52), with each of which pump modules (20) and brake capillaries (18, 19) differently dimensioned in a solvent-specific manner are coordinated.

## Revendications

1. Procédé servant à préparer et à effectuer des mesures RMN sur des échantillons de substrat, des solutions étant préparées à partir des échantillons (3) au moyen d'un système de pipetage (1) et étant introduites dans une cellule à circulation (16) pour préparer et effectuer des mesures RMN dans un spectromètre (24.3), un dispositif d'alimentation (7) ainsi que le système de pipetage (1) étant rincés, le cas échéant, avec au moins un solvant (8, 9), dans lequel un ordinateur de saisie (54) effectuant l'enregistrement d'un spectre RMN de l'échantillon (3.1) et un ordinateur (53) commandant le système de pipetage (1) accèdent à une arborescence (32) de répertoires commune qui contient des répertoires (33.1 à 33.9) avec des fichiers et des fichiers de commande définissant les échantillons, l'appel de ceux-ci donnant lieu à un passage en revue des répertoires (33.1 à 33.9) de manière imbriquée dans le temps, avec pour résultat un traitement parallèle de différents échantillons de substrat.

2. Procédé selon la revendication 1, **caractérisé en ce que** les étapes de préparation de la solution et de la dilution ainsi que du mélange d'un premier échantillon de substrat (3.1) ont lieu dans un dispositif d'alimentation (7, 24.1) en même temps que l'enregistrement (29) du spectre dans le spectromètre (24.3).

3. Procédé selon la revendication 1, **caractérisé en ce que** des processus de rinçage (28) du dispositif d'alimentation (7) et de l'orifice d'injection (13, 13.1) ont lieu en même temps que l'enregistrement (29) du spectre d'un échantillon de substrat (3.1) précédent dans le spectromètre (24.3).

4. Procédé selon la revendication 1, **caractérisé en ce qu'**avant une nouvelle injection (27.1) d'un échantillon de substrat (3) préparé par la suite dans la cellule à circulation (16), un spectre de la cellule à circulation (16) rincée est enregistré, lequel est comparé avec un spectre de référence de la cellule à circulation (16).

5. Procédé selon la revendication 4, **caractérisé en ce qu'**en cas de concordance des spectres de la cellule à circulation (16) rincée avec le spectre de référence, une nouvelle injection d'un échantillon de substrat (3.1) suivant a lieu dans la cellule à circulation (16) et, en cas de divergence des spectres, un autre rinçage (30) de la cellule à circulation (16) est entrepris.

6. Procédé selon une des revendications précédentes, **caractérisé en ce que** les solvants (8, 9) sont pompés dans des circulations (51, 52) fermées, respectivement séparées, dans le système de pipetage (1) et un module de pompe (20) individuel est coordonné à chaque circulation (51, 52) de solvant.

7. Procédé selon la revendication 1, **caractérisé en ce qu'**on utilise comme solvant (8, 9, 23.1, 23.4) des solvants deutériés de chloroforme et de DMSO-d₆.

8. Dispositif servant à préparer et à effectuer des mesures RMN sur des échantillons de substrat (3.1), un système de pipetage étant prévu pour la préparation des échantillons de substrat (3.1) et une cellule à circulation (16) étant prévue pour la préparation et la réalisation de mesures RMN, ainsi qu'au moins un dispositif de rinçage servant à rincer un dispositif d'alimentation (7) ainsi que le système de pipetage (1) avec au moins un solvant (8, 9), et dans lequel sont en outre prévus un ordinateur de commande (53) pour le système de pipetage (1) et un ordinateur de saisie (54) servant à l'enregistrement de spectres d'échantillons RMN qui accèdent ensemble à une arborescence (32) de répertoires qui contient, dans des répertoires (33.1 à 32.9), des fichiers et des fichiers de commande définissant les échantillons (3.1), afin qu'un traitement parallèle de différents échantillons de substrat ait lieu.

9. Dispositif selon la revendication 8, **caractérisé en ce qu'**un module de pompe HPLC (20) avec contrôle de surpression est utilisé pour raccourcir les temps d'injection (27.1, 27.2) des échantillons dans une boucle (15) d'échantillon.

10. Dispositif selon la revendication 8, **caractérisé en ce que** des zones capillaires de ralentissement (18, 19) spécifiques pour un des solvants (8, 9) sont chaque fois placées après le module de pompe (20).

11. Dispositif selon la revendication 8, **caractérisé en ce que** les échantillons de substrat (3.1) sont placés dans des porte-échantillons (11, 12) et **en ce que** les porte-échantillons (11, 12) présentent au moins deux étages (11.1, 11.2) dans lesquels des conteneurs accueillant les échantillons de substrat (3.1) sont introduits, des ouvertures de passage pour le dispositif d'alimentation (7) étant prévues entre les étages (11.1, 11.2).

12. Dispositif selon la revendication 8, **caractérisé en ce que** le système de pipetage a une aiguille (34) servant au prélèvement d'échantillons et **en ce qu'**une station de rinçage (40) est prévue avec un courant de solvant (39) à appliquer pour un rinçage intérieur ainsi qu'un rinçage extérieur de l'aiguille (34).

13. Dispositif selon la revendication 8, **caractérisé en ce que** le système de pipetage a une aiguille (34) servant au prélèvement d'échantillons et **en ce qu'**un élément filtrant (44, 45) à usage unique qui peut être raclé lors d'un mouvement vertical (49, 50) du dispositif d'alimentation (7) est prévu sur l'aiguille (34) prélevant l'échantillon de substrat (3.1).

14. Dispositif selon la revendication 8, **caractérisé en ce que** les solvants (8, 9) circulent respectivement dans des circulations (51, 52) de solvant fermées auxquelles sont respectivement coordonnés des modules de pompe (20) ainsi que des capillaires de ralentissement (18, 19) dimensionnés différemment de manière spécifique au solvant.
